# EUROPEAN PATENT APPLICATION

(11) **EP 2 955 245 A1**
(43) Date of publication of application: **16.12.2015**
(21) Application number: 14749069.2
(22) Date of filing: 22.01.2014
(51) Int. Cl.: C23C 14/06, B32B 15/08, C23C 14/56, C23C 16/54, H01L 51/50, H05B 33/02, H05B 33/10

(54) **METHOD FOR PRODUCING TRANSPARENT GAS-BARRIER FILM, DEVICE FOR PRODUCING TRANSPARENT GAS-BARRIER FILM, AND ORGANIC ELECTROLUMINESCENCE DEVICE**

(30) Priority: 08.02.2013 JP 2013023298
(71) Applicant: Nitto Denko Corporation, Ibaraki-shi, Osaka 567-8680 (JP)
(72) Inventor: YAMADA, Yasumi, Ibaraki-shi Osaka 567-8680 (JP)
(74) Representative: Grünecker Patent- und Rechtsanwälte PartG mbB
(86) International application number: PCT/JP2014/051187
(87) International publication number: WO 2014/122987

(57) **Abstract**

A method for producing a transparent gas barrier film of the present invention is performed using a roll-to-roll method. The method includes depositing a plurality of layers on a long belt-shaped resin substrate 8 by alternately passing the long belt-shaped resin substrate 8 through a deposition area in which a material containing at least one of metals and semimetals is deposited by generating a plasma and a non-deposition area in which the material is not deposited, wherein a transparent gas barrier layer including the plurality of layers each continuously changing in density in the thickness direction is formed on the resin substrate 8 by changing a distance between the resin substrate 8 and a plasma source 52 in the deposition area.

## Description

### TECHNICAL FIELD

The present invention relates to a method for producing a transparent gas barrier film using a roll-to-roll method and a production apparatus thereof.

### BACKGROUND ART

Various kinds of electronic devices such as liquid crystal display devices, organic EL devices (EL is an abbreviation of electroluminescence), electronic papers, solar cells, and thin film lithium ion batteries have been becoming lighter and thinner in recent years. It is known that many of these devices are degenerated and degraded by water vapor in the air.

For these devices, glass substrates have been heretofore used as their support substrates. However, use of resin substrates has been contemplated in place of glass substrates because resin substrates are excellent in various kinds of characteristics such as lightness, impact resistance, and flexibility. The resin substrate generally has remarkably high permeability to gases such as water vapor as compared to a substrate formed of an inorganic material such as glass. Therefore, for a resin substrate to be used for the above-mentioned devices, it is required to improve a gas barrier property while maintaining its light permeability.

Electronic devices are required to have an extremely high level of gas barrier property as compared to that in food packaging applications. The gas barrier property is represented by, for example, a water vapor transmission rate (hereinafter, referred to as WVTR). The value of WVTR in conventional food packaging applications is about 1 to 10 g·m⁻²·day⁻¹, whereas it is considered that for example, substrates for thin film silicon solar cell and compound thin film-based solar cell applications are required to have a WVTR of 1 × 10⁻³ g·m⁻²·day⁻¹ or less, and substrates for organic EL device applications are required to have a WVTR of 1 × 10⁻⁵ g·m⁻²·day⁻¹ or less. In order to meet the requirement of such a very high gas barrier property, various methods for forming a gas barrier layer on a resin substrate have been proposed (see, for example, Patent Documents 1 and 2). However, the gas barrier property of an inorganic film formed by a vacuum process represented by those methods cannot satisfy the above-mentioned requirement.

Thus, it has been proposed that the gas barrier property is improved by alternately laminating a plurality of inorganic layers and polymer layers to perform hybridization (see, for example, Patent Documents 3 to 5). However, this method is not preferred from the viewpoint of production efficiency and costs because layers of different materials are formed by different processes. Further, there is a problem that since adhesion between the inorganic layer and the polymer layer is not high, delamination by bending occurs, resulting in deterioration of the gas barrier property. Therefore, substrates obtained by this method are not suitable for application to flexible devices.

Patent Document 1: JP H8-164595 A
Patent Document 2: JP 2004-151528 A
Patent Document 3: JP 2996516 B
Patent Document 4: JP 2007-230115 A
Patent Document 5: JP 2009-23284 A

### SUMMARY OF INVENTION

An object of the present invention is to provide a method for producing a transparent gas barrier film having an excellent gas barrier property and including a gas barrier layer having very low internal stress; an apparatus for producing the transparent gas barrier film; and so on.

The present inventors have extensively conducted studies, and resultantly found that the following transparent gas barrier film has an excellent gas barrier property and includes a transparent gas barrier layer having very low internal stress.

The transparent gas barrier film includes: a resin substrate; and a transparent gas barrier layer laminated on the resin substrate and containing at least one of metals and semimetals, wherein the transparent gas barrier layer includes a plurality of layers each continuously changing in density in the thickness direction, and the change in density is a change from a higher density to a lower density or from a lower density to a higher density.

The present inventors have arrived at the present invention for efficiently producing the transparent gas barrier film.

The method for producing the transparent gas barrier film of the present invention is performed using a roll-to-roll method. The method includes depositing a plurality of layers on a long belt-shaped resin substrate by alternately passing the long belt-shaped resin substrate through a deposition area in which a material containing at least one of metals and semimetals is deposited by generating a plasma and a non-deposition area in which the material is not deposited, wherein a transparent gas barrier layer including the plurality of layers each continuously changing in density in the thickness direction is formed on the resin substrate by changing a distance between the resin substrate and a plasma source in the deposition area.

In a preferable production method of the present invention, the change in distance is at least one of a change to increase the distance between the resin substrate and the plasma source and a change to decrease the distance between the resin substrate and the plasma source.

In a more preferable production method of the present invention, the metals and the semimetals contain at least one selected from the group consisting of an oxide, a nitride, a carbide, a nitride oxide, a carbide oxide, a carbide nitride, and a carbide nitride oxide.

In another aspect of the present invention, an apparatus for producing a transparent gas barrier film including a transparent gas barrier layer including a plurality of layers each continuously changing in density in the thickness direction is provided.

The apparatus includes a chamber having a deposition area and a non-deposition area, a plasma source that generates a plasma, a deposition source containing a material including at least one of metals and semimetals, and a conveyor that feeds a long belt-shaped resin substrate, wherein the conveyor is configured to cause the resin substrate to pass through the deposition area and the non-deposition area alternately and feed the resin substrate so as to go away from or get closer to the plasma source when the resin substrate passes through the deposition area.

In a preferable production apparatus of the present invention, the conveyor is configured to feed the long belt-shaped resin substrate so as to draw a helical conveyance track.

In a more preferable production apparatus of the present invention, the deposition area has a part with the highest plasma density and a part with the lowest plasma density depending on plasma irradiation from the plasma source, the conveyor has one guide roller around which the long belt-shaped resin substrate is helically wound, and the guide roller has a shaft disposed in a direction orthogonally crossing a virtual line connecting the part with the highest plasma density and the part with the lowest plasma density.

In a more preferable production apparatus of the present invention, the deposition area has a part with the highest plasma density and a part with the lowest plasma density depending on plasma irradiation from the plasma source, the conveyor has a plurality of guide rollers that feed the long belt-shaped resin substrate in a long direction, and among the guide rollers, at least guide rollers provided in the deposition area each have a shaft disposed in a direction orthogonally crossing a virtual line connecting the part with the highest plasma density and the part with the lowest plasma density.

In a more preferable production apparatus of the present invention, the apparatus further includes a reaction gas supply device that supplies a reaction gas into the chamber.

In another aspect of the present invention, an organic EL device is provided.

One organic EL device includes a support substrate, and an organic EL layer formed on the support substrate and having first electrode layer, an organic layer containing a light-emitting layer, and a second electrode layer, wherein the support substrate includes a transparent gas barrier film obtained by the above production method or the above production apparatus.

Another organic EL device includes a support substrate, an organic EL layer formed on the support substrate and having first electrode layer, an organic layer containing a light-emitting layer, and a second electrode layer, and a sealing member sealing the organic EL layer, wherein the sealing member includes a transparent gas barrier film obtained by the production method or the above production apparatus.

With the production method and the production apparatus of the present invention, a gas barrier film excellent in a gas barrier property and including a gas barrier layer having very low internal stress can be produced efficiently.

### BRIEF DESCRIPTION OF DRAWINGS

Fig. 1 is a plan view illustrating one example of a transparent gas barrier film of the present invention.
Fig. 2 is an enlarged sectional view taken along the line II-II in Fig. 1.
Fig. 3 is a schematic view illustrating one example of a density distribution in the thickness direction of a transparent gas barrier layer of a transparent gas barrier film.
Fig. 4 is a schematic view illustrating another example of a density distribution in the thickness direction of a transparent gas barrier layer of a transparent gas barrier film.
Fig. 5 is a sectional view illustrating one example of an organic EL device of the present invention.
Fig. 6 is a front view illustrating an outline of an apparatus for producing a transparent gas barrier film according to a first embodiment.
Fig. 7 is a left side view of the production apparatus.
Fig. 8 is a schematic view illustrating for a reference of a process of forming a plurality of deposited layers each continuously changing in density in the thickness direction.
Fig. 9 is a front view illustrating an outline of an apparatus for producing a transparent gas barrier film according to a second embodiment.
Fig. 10 is a left side view of the production apparatus.

### DETAILED DESCRIPTION OF THE INVENTION

Hereinafter, the present invention will be described with reference to the drawings. It should be noted that dimensions such as a layer thickness and a length in the drawings are different from actual dimensions.

In this specification, as prefixes of the terms "first" and "second" may be added. These prefixes, however, are only added in order to distinguish the terms and do not have specific meaning such as order and relative merits. The "long belt-shape" means a substantially rectangular shape in which a length in one direction is sufficiently larger than a length in the other direction. For example, the "long belt-shape" is a substantially rectangular shape in which a length in one direction is 10 times or more, preferably 30 times or more, more preferably 100 times or more of a length in the other direction. The "long direction" is one direction of the long belt-shape (direction parallel to the longer side of the long belt-shape), and the "short direction" is the other direction of the long belt-shape (direction parallel to the shorter side of the long belt-shape). The wording "PPP to QQQ" means "PPP or more and QQQ or less".

### [Transparent Gas Barrier Film]

A transparent gas barrier film obtained by the production method and the production apparatus according to the present invention includes: a resin substrate; and a transparent gas barrier layer laminated on the resin substrate and containing at least one of metals and semimetals.

The transparent gas barrier layer includes a plurality of layers each continuously changing in density in the thickness direction, and the change in density is a change from a higher density to a lower density or from a lower density to a higher density. In the present invention, the layer continuously changing in density in the thickness direction is formed by depositing on a resin substrate a material containing a metal or a semimetal.

Hereinafter, the layer continuously changing in density in the thickness direction may be referred to as a "deposited layer", and when it is necessary to discriminate a plurality of such layers each continuously changing in density in the thickness direction, the term thereof may be preceded by the term "first", "second" or the like.

The transparent gas barrier layer contains at least one of metals and semimetals. The at least one of metals and semimetals is preferably at least one selected from the group consisting of an oxide, a nitride, a carbide, a nitride oxide, a carbide oxide, a carbide nitride, and a carbide nitride oxide. Examples of the metal include aluminum, titanium, indium, and magnesium. Examples of the semimetal include silicon, bismuth, and germanium. Preferably, carbon and nitrogen that densify a network structure (mesh-like structure) in a transparent gas barrier layer is contained for improving the gas barrier property. Further, oxygen is preferably contained for improving transparency. Particularly preferably, the component of the transparent gas barrier layer contains at least one of metals and semimetals, and all of carbon, oxygen, and nitrogen.
Such a component is typically a carbide nitride oxide of a metal or a semimetal.

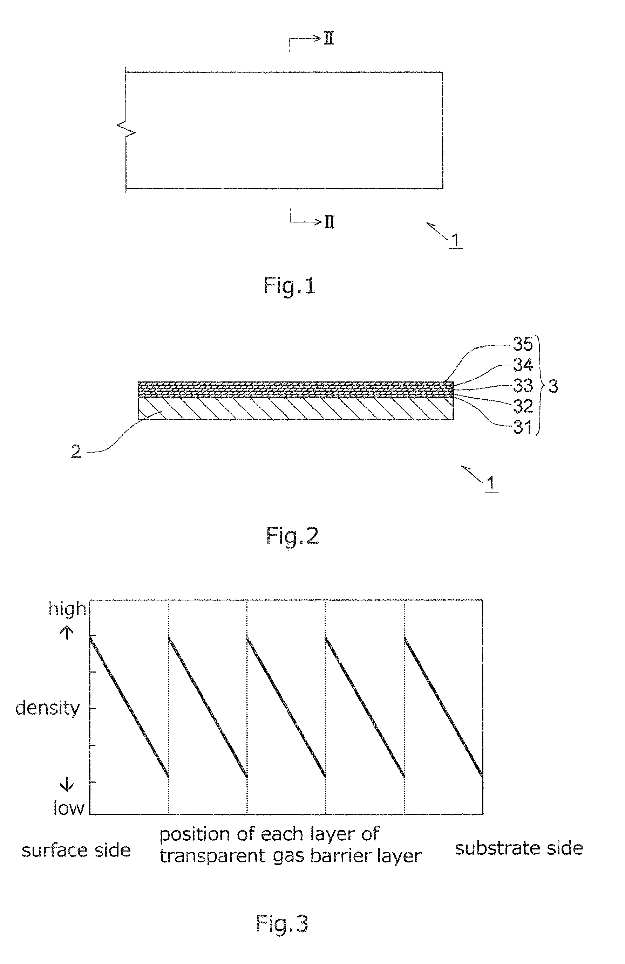

Fig. 1 is a plan view of a transparent gas barrier film, and Fig. 2 is a sectional view obtained by cutting the film in the thickness direction.

A transparent gas barrier film 1 includes a transparent gas barrier layer 3 on a resin substrate 2. The transparent gas barrier layer 3 includes first to fifth deposited layers 31, 32, 33, 34, and 35 each continuously changing in density in the thickness direction. Preferably, the densities of the first to fifth deposited layers 31 to 35 are each continuously and periodically changed in the thickness direction. The densities of the deposited layers 31 to 35 are changed from a higher density to a lower density or from a lower density to a higher density in the thickness direction.

In the illustrated example, the transparent gas barrier layer 3 is composed of five layers: first to fifth deposited layers 31 to 35, but the present invention is not limited thereto. For example, the transparent gas barrier layer may be composed of two layers or three or more layers each continuously changing in density in the thickness direction (none of which is illustrated).

The transparent gas barrier layer 3 may include a layer which does not continuously change in density as long as the transparent gas barrier layer 3 includes a plurality of layers each continuously changing in density in the thickness direction.

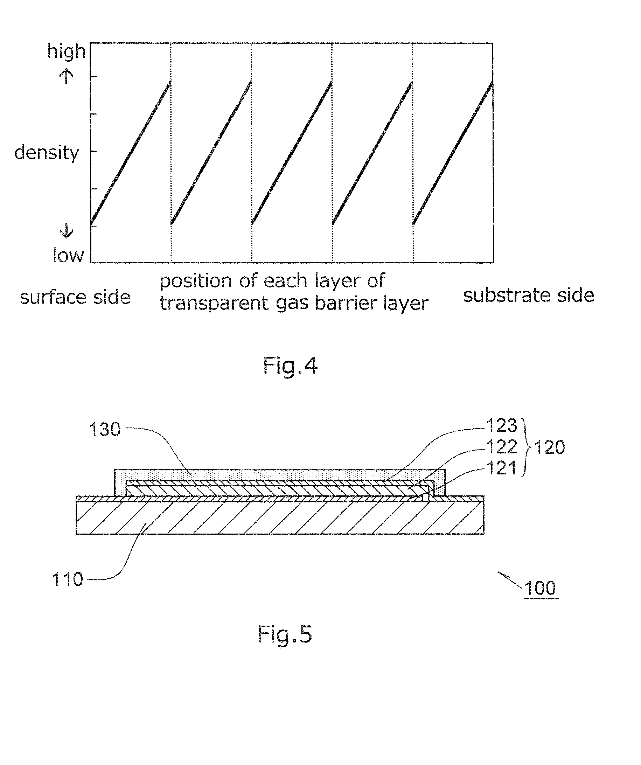

Figs. 3 and 4 are schematic views each illustrating an example of a density distribution in the thickness direction of the gas barrier layer in the transparent gas barrier film. These schematic views also illustrate a transparent gas barrier layer formed of five layers (first to fifth deposited layers), but the number of deposited layers is not limited thereto.

In the example of a density distribution illustrated in Fig. 3, the deposited layers that form the transparent gas barrier layer each gradually increase in density from the resin substrate toward the surface side of the transparent gas barrier layer. Therefore, the transparent gas barrier layer has a repetition of patterns in which the density is gradually increased (from lower density to higher density) in the thickness direction.

In the example of a density distribution illustrated in Fig. 4, the deposited layers that form the transparent gas barrier layer each gradually decrease in density from the resin substrate toward the surface side of the transparent gas barrier layer. Therefore, the transparent gas barrier layer has a repetition of patterns in which the density is gradually decreased (from higher density to lower density) in the thickness direction.

The change in density may be linear or curved. The densities of the deposited layers may be the same or different as long as they are continuously changed. The density gradients of the deposited layers may be the same or different.

Generally, a high gas barrier property can be obtained by forming a high-density layer, but when the thickness of the high-density layer is increased or the layer and an another layer is laminated to form a laminated structure, internal stress increases, leading to generation of microcracks, so that the gas barrier property is easily deteriorated.

Thus, by forming a transparent gas barrier layer including a plurality of layers each continuously changing in density as described above, internal stress can be reduced. Therefore, the transparent gas barrier film of the present invention can resist generation of microcracks, so that a high gas barrier property can be achieved. The reason why such a high gas barrier property can be achieved is not clear, but a change in density with a certain layer thickness tends to reduce stress as compared to a change in density with a random layer thickness.

The ratio (Y/X) of a maximum value (Y) to a minimum value (X) of the density in the transparent gas barrier layer is preferably 1.1 or more. When the ratio of Y to X is close to 1, so that a difference therebetween is small, any of gas barrier property improvement and internal stress reduction functions may become insufficient. While the density of the transparent gas barrier layer varies depending on a formation material, a composition, and a formation method thereof, for example, the density of the transparent gas barrier layer is 1.6 to 2.2 g·cm⁻³ when the material is silicon oxide, and is 2.3 to 2.7 g·cm⁻³ when the material is silicon nitride.

In view of a gas barrier property, transparency, a film formation time, and internal stress of the film, the thickness of the transparent gas barrier layer is preferably 1 µm or less, more preferably in a range of 100 nm to 800 nm, further preferably in a range of 200 nm to 500 nm. The thicknesses of the deposited layers changing in density in the thickness direction are, each independently, preferably in a range of 50 nm to 200 nm, more preferably in a range of 10 nm to 100 nm. The thicknesses of the deposited layers may be the same, or each independently different, but preferably, the deposited layers are formed in the same thickness.

The number of the deposited layers changing in density in the thickness direction is 2 or more, preferably in a range of 3 to 20, more preferably in a range of 5 to 16.

The resin substrate is flexible. The flexible resin substrate is a flexible sheet-shaped article which can be wound around a roll. For the resin substrate, a transparent resin substrate is used.

As the resin substrate, it is preferred to use a substrate having high heat resistance, particularly a substrate which has a high Tg (glass transition temperature) and is hard to be thermally shrunk in consideration of influences of heating by radiant heat from a plasma or deposition source. When a substrate which has a low Tg or is easily thermally shrunk is used, distortion may occur in the substrate at the time of forming a transparent gas barrier layer, so that cracks etc. are generated in the transparent gas barrier layer, leading to deterioration of the gas barrier property. Thus, it is preferred to use a transparent film having high heat resistance as the resin substrate. For example, the resin film is preferably a resin film having a shrinkage factor of 0.5% or lower in both a short direction (TD) and a long direction (MD).

Specific examples of the resin film include transparent films composed of cycloolefin polymers, polyethylene naphthalate, polyethylene sulfide, polyphenyl sulfide, polycarbonate, polyimide, polyamide, and the like.

The thickness of the resin substrate is preferably 20 µm to 200 µm, particularly preferably 50 µm to 150 µm from the viewpoint of handling.

The width of the resin substrate is not particularly limited, but is preferably 50 mm or less, for example.

The resin substrate may be subjected to a surface modifying treatment such as a corona discharge treatment, a plasma discharge treatment, or an ion etching (RIE) treatment on a surface thereof (a surface to be provided with a transparent gas barrier layer). Alternatively, the surface of the resin substrate may be provided with an inorganic substance layer or a polymer layer as a smooth layer and an adhesive layer.

### [Applications of Transparent Gas Barrier Film]

A transparent gas barrier film obtained by the production method and production apparatus of the present invention can be used for various applications. Particularly, the transparent gas barrier film of the present invention has an excellent gas barrier property and good flexibility, and therefore can be suitably used as a constituent member of various kinds of electronic devices. For example, the transparent gas barrier film of the present invention can be used for a support substrate or a sealing member of an organic EL device; a coating film of a solar cell; a coating film of a thin film battery; and so on.

For example, the organic EL device 100 as illustrated in Fig. 5 includes a support substrate 110, an organic EL layer 120, and a sealing layer 130. The organic EL (organic electroluminescence) layer 120 is composed of a laminate having a first electrode layer 121 provided on the support substrate 110, an organic layer 122 including a light emitting layer provided on the first electrode 121, and a second electrode layer 123 provided on the organic layer 122. The sealing member 130 is provided on the laminate (on the second electrode 123). A transparent gas barrier film of the present invention can be used as at least one of the support substrate 110 and the sealing member 130.

The first electrode layer is, for example, an anodic layer, although it may be either anodic or cathodic. Examples of the anodic layer include transparent electrode layers such as ITO (Indium Tin Oxide) and IZO (registered trademark; Indium Zinc Oxide). The organic layer includes a light-emitting layer, and includes at least one selected from a hole injection layer, a hole transport layer, an electron transport layer, and an electron injection layer as necessary. The second electrode layer is, for example, a cathodic layer, although it may be either cathodic or anodic.
Examples of the cathodic layer include an aluminum layer, a magnesium/aluminum layer, and a magnesium/silver layer.

The sealing member may have a monolayer structure, or a multi-layer structure. When the sealing member has a multi-layer structure, the transparent gas barrier film of the present invention is used for at least one layer thereof.

When the transparent gas barrier film of the present invention is used as a sealing member, an organic EL device having an excellent gas barrier property can be formed by fixing the transparent gas barrier film to the laminate using fixation means such as an adhesive or heat seal.

When the transparent gas barrier film of the present invention is used as a support substrate of the organic EL device, the organic EL device can be made lighter, thinner and more flexible.

The organic EL device using the transparent gas barrier film of the present invention as a support substrate serves as a flexible display, and can be used in the form of an electronic paper when rolled, for example. When the transparent gas barrier film of the present invention is used as a sealing member, an organic EL layer is easily sealed, and a thin organic EL device can be obtained.

For example, the solar cell includes a solar battery cell, and the solar battery cell is coated with the transparent gas barrier film of the present invention. Particularly, the transparent gas barrier film can also be suitably used as a light-receiving-side front sheet and a protecting back sheet of a solar cell. One example of the structure of the solar cell is a structure in which a solar battery cell formed of a silicon thin film or a CIGS (Copper Indium Gallium DiSelenide) thin film is sealed with a resin of an ethylene-vinyl acetate copolymer etc., and further caught by the transparent gas barrier film of the present invention. Sealing with the resin may be omitted to catch the solar battery cell directly by the transparent gas barrier film of the present invention.

For example, the thin film battery includes a laminate including a current-collecting layer, an anodic layer, a solid electrolyte layer, a cathodic layer, and a current-collecting layer in this order, and the laminate is coated with the transparent gas barrier film of the present invention. Examples of the thin film battery include thin film lithium ion batteries. Specifically, in the thin film battery, a current-collecting layer provided on a substrate and composed of a metal, an anodic layer composed of a metal inorganic film, a solid electrolyte layer, a cathodic layer, and a current-collecting layer composed of a metal are laminated in this order. The transparent gas barrier film of the present invention can also be used as a substrate of the thin film battery.

### [Regarding Production Method of Transparent Gas Barrier Film and Production Apparatus thereof]

The production method of the transparent gas barrier film includes depositing a plurality of layers on a long belt-shaped resin substrate by alternately passing the long belt-shaped resin substrate through a deposition area in which a material containing at least one of metals and semimetals is deposited by generating a plasma and a non-deposition area in which the material is not deposited. In this deposition area, a transparent gas barrier layer including a plurality of layers each continuously changing in density in the thickness direction is formed on the resin substrate by changing a distance between the resin substrate and a plasma source.

According to the production method of the present invention, in the step of feeding a long belt-shaped resin substrate in the long direction, a plurality of layers each continuously changing in density in the thickness direction can be laminated on a surface of the resin substrate.

The change in distance between the resin substrate and the plasma source is preferably at least one of a change to increase the distance between the resin substrate and the plasma source and a change to decrease the distance between the resin substrate and the plasma source.

Further, the at least one of metals and semimetals is preferably at least one selected from the group consisting of an oxide, a nitride, a carbide, a nitride oxide, a carbide oxide, a carbide nitride, and a carbide nitride oxide.

The WVTR of a transparent gas barrier film obtained by the production method of the present invention is 0.01 g·m⁻²·day⁻¹ or less, preferably 0.001 g·m⁻²·day⁻¹ or less.

The production apparatus of the present invention is used for carrying out the production method.

That is, the production apparatus of the present invention is an apparatus that is applied for producing a transparent gas barrier film including a transparent gas barrier layer including a plurality of layers each continuously changing in density in the thickness direction.

The production apparatus includes a chamber having a deposition area and a non-deposition area; a plasma source that generates a plasma; a deposition source containing a material including at least one of metals and semimetals; and a conveyor that feeds a long belt-shaped resin substrate, and further preferably includes a reaction gas supply device that supplies a reaction gas into the chamber.

The plasma source and the deposition source are provided in the chamber.

The conveyor is configured to cause the resin substrate to pass through the deposition area and the non-deposition area alternately and feed the resin substrate so as to go away from or get closer to the plasma source when the resin substrate passes through the deposition area.

Hereinafter, the method and the apparatus will be described in detail.

### [First Embodiment of Production Method and Production Apparatus of the Present Invention]

The production method and the production apparatus of the first embodiment have the following aspect: by feeding a long belt-shaped resin substrate so as to draw a helical conveyance track using one guide roller, a plurality of deposited layers are sequentially laminated on a surface of the resin substrate while the resin substrate is caused to pass through a deposition area and a non-deposition area alternately.

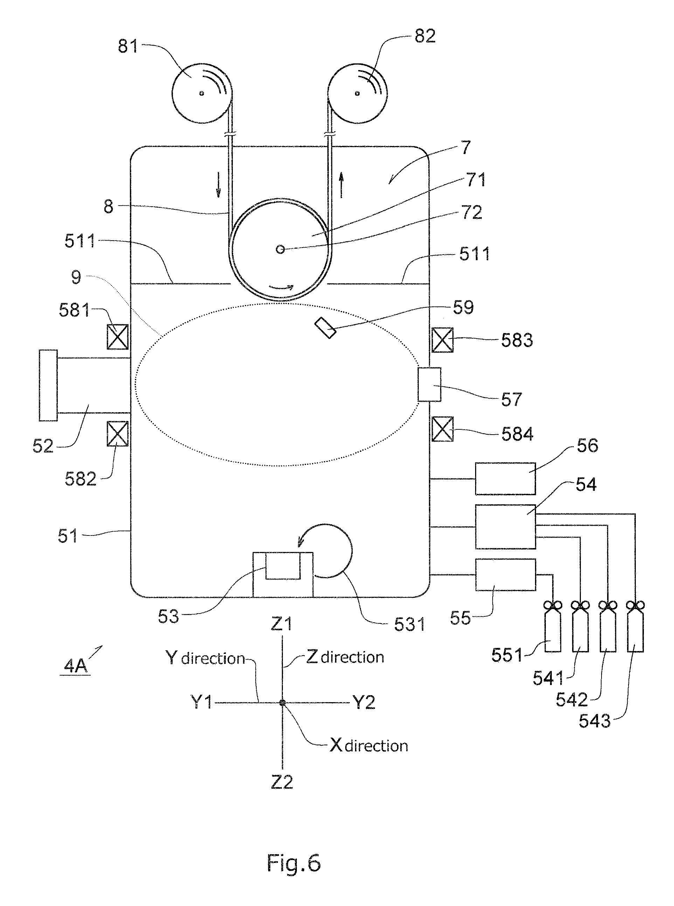

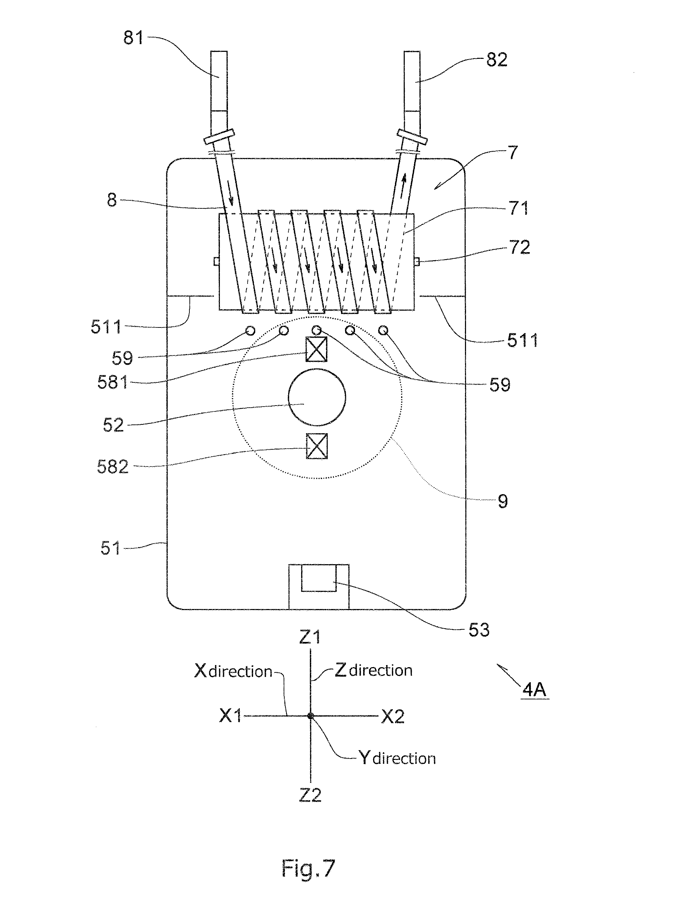

Figs. 6 and 7 illustrate an example of a configuration of the production apparatus of the first embodiment.

Hereinafter, in each drawing illustrating each production apparatus, a direction orthogonally crossing a horizontal plane is referred to as a "Z direction", a direction orthogonally crossing the Z direction is referred to as an "X direction" and a direction orthogonally crossing the Z direction and X direction is referred to as a "Y direction" for the sake of convenience. Further, one side in the X direction is referred to as an "X1 side" and the opposite side in the X direction (side opposite to the one side) is referred to as an "X2 side"; one side in the Y direction is referred to as a "Y1 side" and the opposite side in the Y direction (side opposite to the one side) is referred to as a "Y2 side"; and one side in the Z direction is referred to as a "Z1 side" and the opposite side in the Z direction (side opposite to the one side) is referred to as a "Z2 side".

Fig. 6 is a front view of the production apparatus seen from the X2 side in the X direction (direction from X2 to X1), and Fig. 7 is a left side view of the production apparatus seen from the Y1 side in the Y direction (direction from Y1 to Y2).

A production apparatus 4A includes a chamber 51, the inside of which can be held in vacuum; a conveyor 7 that continuously feeds a long belt-shaped resin substrate 8; a plasma source 52 that generates a plasma; a deposition source 53 containing a material to be deposited; a reaction gas supply device 54 that supplies a reaction gas into the chamber 51; a discharge gas supply device 55 that supplies a discharge gas into the chamber 51; and a vacuum pump 56 that brings the inside of the chamber 51 into a vacuum state.

The principal part of the conveyor 7 is provided in the chamber 51, and the plasma source 52 and the deposition source 53 are provided in the chamber 51.

In the chamber 51, a partition wall 511 that separates the deposition area and the non-deposition area from each other is provided. The deposition area is one region in the chamber 51, at which a material can be deposited on an adherend (i.e. long belt-shaped resin substrate 8). The non-deposition area is the other region in the chamber 51, at which a material is not deposited on an adherend. In the illustrated example, with the partition wall 511 as a reference, a region on the Z2 side (lower side) with respect to the partition wall 511 is the deposition area, and a region on the Z1 side (upper side) with respect to the partition wall 511 is the non-deposition area.

Of course, it is not necessarily required to provide the partition wall 511, and it is also possible to omit the partition wall 511.

The plasma is not particularly limited, and for example, an arc discharge plasma, a glow discharge plasma, or the like may be used.
An arc discharge plasma is preferably used because a very high electron density is achieved unlike a glow discharge plasma. By using an arc discharge plasma, reactivity of a material can be enhanced, so that a very dense transparent gas barrier layer can be formed on a resin substrate.

As an arc discharge plasma generation source (plasma source 52), for example, a pressure gradient type plasma gun, a direct-current discharge plasma generator, a high-frequency discharge plasma generator, or the like may be used. Among them, a pressure gradient type plasma gun is preferably used as the plasma source 52 because a high-density plasma can be stably generated during deposition.

In the illustrated example, a pressure gradient type plasma gun is used as the plasma source 52. The plasma source 52 is provided in, for example, a first side wall (side wall on the Y1 side) of the chamber 51 as illustrated in Fig. 6. On a second side wall (side wall on the Y2 side opposite to the first side wall) of the chamber 51, a reflection electrode 57 is provided to face the pressure gradient type plasma gun. Focusing electrodes 581, 582, 583, and 584 are provided on the circumference of the plasma source 52 and the circumference of the reflection electrode 57. The plasma source 52 is controlled so that a plasma beam 9 is applied toward the reflection electrode 57, and the plasma beam 9 is formed into a necessary shape by the focusing electrodes 581, 582, 583, and 584.

The plasma density is higher at a position closer to the plasma source 52, and is lower at a position farther from the plasma source 52. In the illustrated example, the plasma density increases as going toward the Y1 side, and the plasma density decreases as going toward the Y2 side. Therefore, the deposition area in the chamber 51 has a part with the highest plasma density and a part with the lowest plasma density. Usually, the part with the highest plasma density is positioned in the vicinity of the plasma source 52, and the part with the lowest plasma density is positioned in the vicinity of the reflection electrode 57. A virtual line connecting the part with the highest plasma density and the part with the lowest plasma density is parallel to the Y direction.

The deposition source 53 is installed on the bottom of the chamber 51 so as to face the conveyor 7. A material to be deposited is placed on the upper surface of the deposition source 53.

As means for evaporating the material placed in the deposition source 53, the plasma may be used, but resistance heating or an electron beam may also be used.

The material placed in the deposition source 53 can be appropriately selected from a metal, a semimetal, and an oxide, a nitride, a carbide, a nitride oxide, a carbide oxide, a carbide nitride, and a carbide nitride oxide thereof. When the material is deposited in the presence of a reaction gas as in this embodiment, a deposited layer can be formed while a component of the reaction gas is introduced into the material in the deposition source 53.

For example, when a material containing at least one of metals and semimetals is used as the above-mentioned material, the deposited layer composed of an oxide, a nitride, a carbide, a nitride oxide, a carbide oxide, a carbide nitride, or a carbide nitride oxide can also be formed by depositing the material with a plasma generated in the presence of a reaction gas. Of course, the foregoing oxide, nitride, carbide, nitride oxide, carbide oxide, carbide nitride, or carbide nitride oxide may be used as the material placed in the deposition source 53.

The reaction gas supply device 54 is provided on, for example, the second side wall of the chamber 51. The same number of reaction gas storage cylinders 541, 542, and 543 as the number of reaction gases are connected to the reaction gas supply device 54, and the reaction gas supply device 54 supplies a reaction gas at an appropriate pressure into the chamber 51.

Examples of the reaction gas include oxygen-containing gas, nitrogen-containing gas, hydrocarbon-containing gas, and mixture of these gases. Examples of the oxygen-containing gas include oxygen (O₂), dinitrogen monoxide (N₂O), and nitric oxide (NO), examples of nitrogen-containing gas include nitrogen (N₂), anmonia (NH₃), and nitric oxide (NO), and examples of hydrocarbon-containing gas include methane (CH₄), ethane (C₂H₆), propane (C₃H₈), butane (C₄H₁₀), ethylene (C₂H₄), and acethylene (C₂H₂).

The discharge gas supply device 55 is provided on, for example, the second side wall of the chamber 51. A discharge gas storage cylinder 551 is connected to the discharge gas supply device 55, and the discharge gas supply device 55 supplies a discharge gas at an appropriate pressure into the chamber 51. As the discharge gas, typically an inert gas such as an argon gas may be used.

The vacuum pump 56 is provided on, for example, the second side wall of the chamber 51. By actuating the vacuum pump 56, the inside of the chamber 51 can be evacuated into a vacuum state.

The conveyor 7 conveys the long belt-shaped resin substrate 8 in its long direction by so called a roll-to-roll method.

In this embodiment, the conveyor 7 helically conveys the resin substrate 8, and guides the resin substrate 8 to the deposition area and the non-deposition area alternately.

As such a conveyor 7 that performs helical conveyance, for example, an apparatus disclosed in Japanese Patent Laid-Open Publication No. 2009-209438 can be used.

The conveyor 7 in this embodiment has one guide roller 71 for feeding the long belt-shaped resin substrate 8 in the long direction while drawing a helical track. The lower part of the guide roller 71 is exposed to the deposition area for guiding the resin substrate 8 to the deposition area.

The long belt-shaped resin substrate 8 is helically wound around the circumferential surface of the guide roller 71 from the X1 side to the X2 side. Therefore, the resin substrate 8 helically wound around the guide roller 71 passes through the deposition area at the lower part of the guide roller 71, and passes through the non-deposition area at the upper part of the guide roller 71.

The guide roller 71 is a cylindrical roller centering on a shaft 72.
A direction along which the shaft 72 extends (axis direction) is parallel to the X direction. Therefore, the shaft 72 is extended in a direction which orthogonally crosses the direction of the virtual line connecting the part with the highest plasma density and the part with the lowest plasma density (Y direction).

The guide roller 71 may be configured to be able to rotate about the shaft 72, or may be fixed to the shaft 72. For smoothly feeding the resin substrate 8, a guide groove or a guide projection (not illustrated) etc. may be formed on the circumferential surface of the guide roller 71.

In the illustrated example, the resin substrate 8 is wound around the guide roller 71 so that the resin substrate 8 intermittently passes through the deposition area five times while being helically conveyed.

A crystal monitor 59 for measuring and controlling the deposition rate is provided in the vicinity of the resin substrate 8 passing through the deposition area. The crystal monitor 59 is provided at five locations at equal intervals in correspondence with the number of times the resin substrate 8 enters the deposition area.

A temperature controller (not illustrated) may be attached to the guide roller 71 as necessary. The temperature controller is provided for adjusting the surface temperature of the guide roller 71. Examples of the temperature controller include a heat medium circulation device for circulating silicone oil etc.

The long belt-shaped resin substrate 8 drawn out from a roll 81 on the upstream side is fed from the Z1 side to the Z2 side, wound around the lower circumferential surface of the guide roller 71, then fed from the Z2 side to the Z1 side, and wound around the upper circumferential surface of the guide roller 71 while being slightly inclined. When the resin substrate 8 is passing over the lower circumferential surface of the guide roller 71, the resin substrate 8 is fed from the Y1 side to the Y2 side (in Y direction). When the resin substrate 8 is passing over the upper circumferential surface of the guide roller 71, the resin substrate 8 is fed from the Y2 side to the Y1 side (in Y direction).

Further, the long belt-shaped resin substrate 8 is wound around the upper circumferential surface of the guide roller 71, and then similarly fed from the lower circumferential surface to the upper circumferential surface of the guide roller 71 in succession while drawing a helical track. Therefore, the resin substrate 8 is fed while drawing a helical track clockwise as a whole as seen from the X1 side, and wound around a roll 82 on the downstream side. Accordingly, the conveyor 7 is configured to feed the resin substrate 8 while passing the resin substrate 8 through the deposition area and the non-deposition area alternately.

Conveyance of the resin substrate 8 wound around the guide roller 71 is performed by, for example, unwinding operations of the roll 81 on the upstream side and winding operations of the roll 82 on the downstream side.

However, when the resin substrate 8 passes through the deposition area, the resin substrate 8 is fed in the Y direction (from the Y1 side to the Y2 side) as illustrated in Fig. 6. In the production apparatus 4A of this embodiment in which the plasma source 52 is disposed on the Y1 side, the resin substrate 8 is fed so as to go away from the plasma source 52 at the time of passing the resin substrate 8 through the deposition area.

A method for producing a transparent gas barrier film will now be described. Hereinafter, a method for producing a transparent gas barrier film using the production apparatus 4A illustrated in Figs. 6 and 7 will be described, but the production method of the present invention is not limited to production using the production apparatus 4A.

By actuating the vacuum pump 56, the inside of the chamber 51 is kept in a vacuum state. The pressure of the inside of the chamber 51 in formation of a deposited layer on the resin substrate 8 falls within a range of 0.01 Pa to 0.1 Pa, preferably 0.02 Pa to 0.05 Pa.

In the deposition area in the chamber 51, a discharge gas is introduced from the discharge gas supply device 55 into a pressure gradient type plasma gun as the arc discharge plasma generation source 52, and a constant voltage is applied to apply a plasma toward the reflection electrode 57. The shape of the plasma beam 9 is controlled to necessary shape by the focusing electrodes 581, 582, 583 and 584. The power of the arc discharge plasma is, for example, 1 to 10 kW. A reaction gas is introduced into the chamber 51 from the reaction gas supply device 54. A material placed in the deposition source 53 is irradiated with, for example, an electron beam 531 to evaporate the material toward the resin substrate 8.

Introduction of the reaction gas and generation of the plasma may be performed in parallel, or the plasma may be generated after introduction of the reaction gas, or the reaction gas may be introduced after generation of the plasma. The reaction gas is only required to exist in the deposition area during formation of a transparent gas barrier layer.

Preferably, an opening/closing shutter (not illustrated) is provided between the deposition source 53 and the resin substrate 8 beforehand, the shutter is closed after the start of evaporation of the material until the deposition rate is stabilized, and after the deposition rate is stabilized, the shutter is opened to deposit the material on the resin substrate 8.

The deposition rate of the material can be appropriately set, and is, for example, 10 to 300 nm/minute.

On the other hand, the long belt-shaped resin substrate 8 is drawn out from the roll 81 on the upstream side, and introduced into the chamber 51. In the illustrated example, rolls 81 and 82 are disposed outside the chamber 51, but may be disposed on the non-deposition area in the chamber 51.

The length of the long belt-shaped resin substrate 8 in the short direction is not particularly limited, and it can be appropriately set, and is, for example, several mm to 1000 mm, preferably several mm to 50 mm.

For example, when a transparent gas barrier film to be used as a support substrate of an organic EL device is produced, the length of the long belt-shaped resin substrate 8 in the short direction is set to, for example, several mm to 100 mm, preferably several mm to about 50 mm.

The resin substrate 8 is wound around the guide roller 71 of the conveyor 7, and the resin substrate 8 is fed so as to draw a helical track, and caused to pass through the deposition area and the non-deposition area alternately.

The conveyance speed of the resin substrate 8 can be appropriately set in consideration of the deposition rate and the thickness of a deposited layer formed etc., and is, for example, 0.1 to 20 m/minute.

When the resin substrate 8 sequentially passes through the deposition area (i.e. when the resin substrate 8 passes over the lower part of the guide roller 71), the material is deposited on the resin substrate 8, so that deposited layers are formed one after another.

As described above, when the resin substrate 8 passes through the deposition area, the resin substrate 8 moves from the Y1 side to the Y2 side, and therefore goes away from the plasma source 52. Therefore, in the deposition area, the distance between the resin substrate 8 and the plasma source 52 is changed (changed to increase the distance in this case), so that a plurality of deposited layers each continuously changing in density in the thickness direction can be formed.

For promoting deposition in the deposition area, the surface temperature of the resin substrate 8 is set to, for example, 20°C to 200°C, preferably 80°C to 150°C.

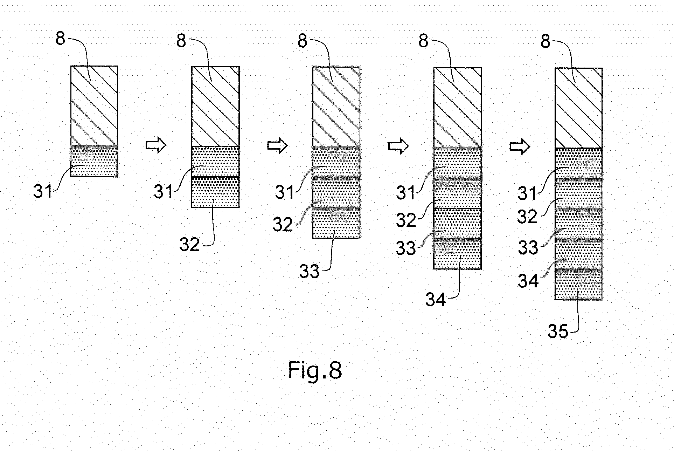

Specifically, when the resin substrate 8 passes through the deposition area by way of the circumferential surface of the guide roller 71, the material is deposited on a surface of the resin substrate 8 to form a first deposited layer. In this embodiment in which in the deposition area, the resin substrate 8 is fed so as to go away from the plasma source 52, the density of the material contained in the deposited layer gradually decreases. Thus, a first deposited layer 31 is formed in which the density on the surface side of the resin substrate 8 is the highest, and the density decreases as going away from the resin substrate 8 as illustrated in Fig. 8.

The resin substrate 8 provided with the first deposited layer 31 passes through the non-deposition area by way of the upper circumferential surface of the guide roller 71, and is then guided to the deposition area by passing over the circumferential surface of the guide roller 71 again. At this time, the material is deposited on the surface of the first deposited layer 31 to form a second deposited layer 32. Similarly to the first deposited layer 31, the second deposited layer 32 continuously decreases in density as going away from the resin substrate 8.

Thereafter, similarly a third deposited layer 33 changing in density is formed on the surface of the second deposited layer 32, a fourth deposited layer 34 changing in density is formed on the surface of the third deposited layer 33, and a fifth deposited layer 35 changing in density is formed on the surface of the fourth deposited layer 34 as illustrated in Fig. 8. Accordingly, a transparent gas barrier layer including a plurality of deposited layers 31 to 35 (five layers in the illustrated example) each continuously changing in density in the thickness direction can be formed on the resin substrate 8. In this way, a deposited layer is formed each time the resin substrate 8 passes through the deposition area. Therefore, the number of deposited layers formed is identical to the number of times the resin substrate passes through the deposition area.

According to the production apparatus and the production method of the present invention, a plurality of deposited layers can be continuously formed on the long belt-shaped resin substrate 8 using a roll-to-roll method, so that a transparent gas barrier film including a plurality of layers each continuously changing in density in the thickness direction can be efficiently produced. Such a transparent gas barrier film has a plurality of layers each continuously changing in density in the thickness direction, and therefore has an excellent gas barrier property and very low internal stress.

Particularly, according to the production apparatus and the production method of this embodiment, a transparent gas barrier film including a plurality of deposited layers having substantially the same density distribution and density gradient as illustrated in Fig. 3 or 4 can be formed.

In the first embodiment, an apparatus and a method, which are capable of forming a plurality of deposited layers each continuously decreasing in density as going away from a surface of the resin substrate 8 as illustrated in Fig. 4, are illustrated as an example, but a plurality of deposited layers each continuously increasing in density as going away from a surface of the resin substrate 8 as illustrated in Fig. 3 can also be formed.

These deposited layers can be obtained by, for example, modifying the production apparatus 4A as described in (1) or (2) below.
(1) The conveyance direction of the resin substrate is inverted. That is, the resin substrate 8 is drawn out from the roll 82 on the downstream side, conveyed through the deposition area and the non-deposition area alternately using the conveyor 7, and wound around the roll 81 on the upstream side.
(2) The installation position of the plasma source 52 is changed. That is, the installation position of the plasma source 52 is changed so that the plasma density increases as going toward the Y2 side, and the plasma density decreases as going toward the Y1 side.

### [Second Embodiment of Production Method and Production Apparatus of the Present Invention]

The production method and the production apparatus of the second embodiment have the following aspect: by feeding a long belt-shaped resin substrate so as to draw a helical conveyance track using a plurality of pairs of guide rollers, a plurality of deposited layers are sequentially laminated on a surface of the resin substrate while the resin substrate is caused to pass through a deposition area and a non-deposition area alternately.

Hereinafter, the second embodiment will be described, but descriptions of configurations similar to those in the first embodiment are omitted assuming that they have been already described, and the same terms and symbols are applied.

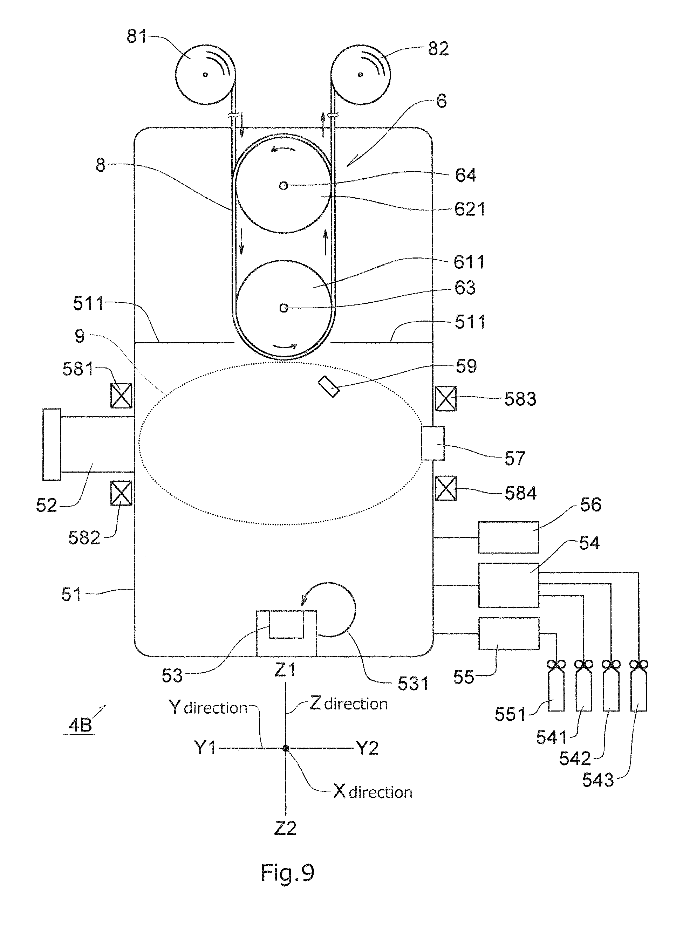

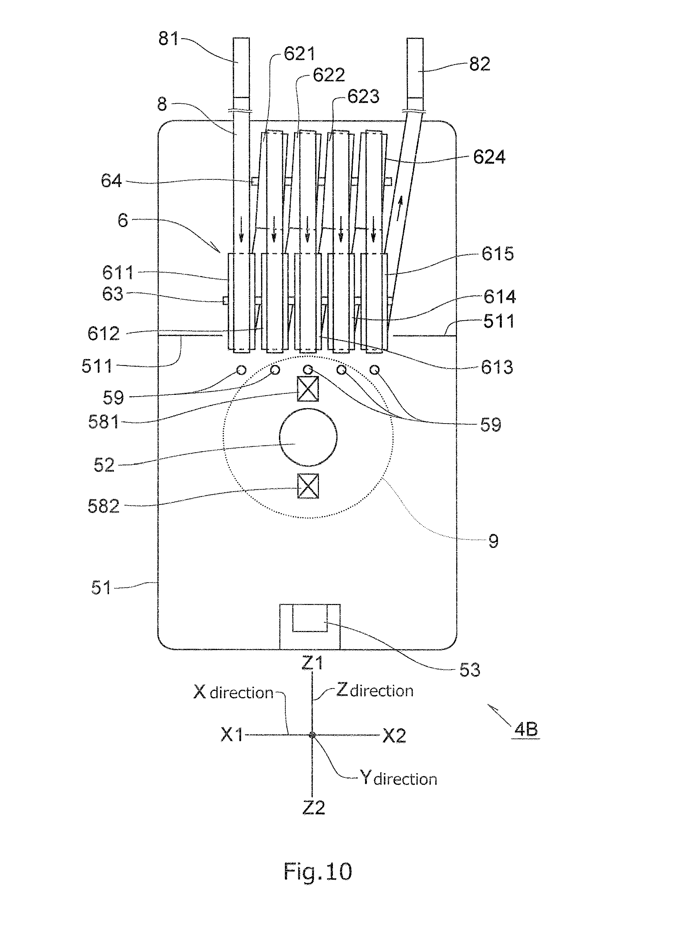

Fig. 9 is a front view of the production apparatus of the second embodiment seen from the X2 side in the X direction, and Fig. 10 is a left side view of the production apparatus seen from the Y1 side in the Y direction.

Similarly to the first embodiment, the production apparatus 4B includes a chamber 51, a conveyor 6, a plasma source 52, a reflection electrode 57, focusing electrodes 581, 582, 583, and 584, a deposition source 53, a reaction gas supply device 54, a discharge gas supply device 55, and a vacuum pump 56.

A conveyor 6 of this embodiment is similar to the conveyor 7 of the first embodiment in that the long belt-shaped resin substrate 8 is conveyed in its long direction by a roll-to-roll method, but the conveyor 6 has a conveyance mechanism different from that in the first embodiment.

Specifically, in this embodiment, the conveyor 6 has a plurality of guide rollers 611 and 612 for feeding the long belt-shaped resin substrate 8 in the long direction. Some of the plurality of guide rollers are provided in the deposited area for guiding the resin substrate 8 to the deposition area.

The conveyor 6 helically conveys the resin substrate 8, and guides the resin substrate 8 to the deposition area and the non-deposition area alternately.

As such a conveyor 6 that performs helical conveyance, for example, an apparatus disclosed in Japanese Patent No. 4472962 can be used.

The conveyor 6 has a basic configuration in which there are a plurality of pairs of guide rollers 611 and 621 that can be rotated so as to feed the long belt-shaped resin substrate 8 in its long direction as illustrated in Figs. 9 and 10.

Of the pair of guide rollers, one is disposed in the deposition area and the other is disposed in the non-deposition area. Hereinafter, the guide roller disposed in the deposition area is referred to as an "inside guide roller" and the guide roller disposed in the non-deposition area is referred to as an "outside guide roller" for the sake of convenience, and prefixes of "first", "second" and so on are added for distinguishing a plurality of guide rollers.

The production apparatus 4B in the illustrated example is an apparatus capable of laminating first to fifth deposited layers on the resin substrate 8, in which the number of the deposited layers is the same as the number of the inside guide rollers (first to fifth inside guide rollers 611, 612, 613, 614, and 615) provided in the deposition area.

The inside guide rollers 611,... (first to fifth inside guide rollers 611 to 615) provided in the deposition area may be wholly included within the deposition area, or may be disposed so as to be partially included within the deposition area as illustrated in the figure.

On the other hand, the outside guide rollers 621,... are disposed on the Z1 side with respect to the inside guide rollers 611, and the number thereof is smaller by 1 than the number of the inside guide rollers 611.

For the first to fifth inside guide rollers 611 to 615, for example, rollers having the same diameter and width can be used. For the first to fourth outside guide rollers 621, 622, 623, and 624, for example, rollers having the same diameter and width can be used.

The first to fifth inside guide rollers 611 to 615 are rotatably attached to a shaft 63, and the first to fourth outside guide rollers 621 to 624 are rotatably attached to a shaft 64. Directions along which the shafts 63 and 64 extend (axis direction) are both parallel to the X direction. Therefore, the shafts 63 and 64 are extended in a direction which orthogonally crosses the direction of the virtual line connecting the part with the highest plasma density and the part with the lowest plasma density (Y direction).

The first to fifth inside guide rollers 611 to 615 are arranged side by side at necessary intervals on the shaft 63, and the first to fourth outside guide rollers 621 to 624 are similarly arranged side by side at necessary intervals on the shaft 64. The interval between adjacent inside guide rollers 611 is preferably as small as possible because the apparatus can be made smaller, and a plurality of deposited layers having a relatively uniform density distribution and density gradient can be formed.

The first to fourth outside guide rollers 621 to 624 are rotatably attached to the shaft 64 while being slightly inclined with respect to the shaft 64 for helically feeding the resin substrate 8 to each guide roller.

A crystal monitor 59 for measuring and controlling the deposition rate is provided in the vicinity of each of the first to fifth inside guide rollers 611 to 615.

A temperature controller (not illustrated) may be attached to each of the first to fifth inside guide rollers 611 to 615 as necessary. The temperature controller is provided for adjusting the surface temperature of the inside guide roller 611. Examples of the temperature controller include a heat medium circulation device for circulating silicone oil etc.

The long belt-shaped resin substrate 8 drawn out from the roll 81 on the upstream side is fed from the Z1 side to the Z2 side, wound around the lower circumferential surface of the first inside guide roller 611, then fed from the Z2 side to the Z1 side, and wound around the upper circumferential surface of the first outside guide roller 621. When the resin substrate 8 is passing over the lower circumferential surface of the first inside guide roller 611, the resin substrate 8 is fed from the Y1 side to the Y2 side (in Y direction). When the resin substrate 8 is passing over the upper circumferential surface of the first outside guide roller 621, the resin substrate 8 is fed from the Y2 side to the Y1 side (in Y direction).

The long belt-shaped resin substrate 8 is wound around the upper circumferential surface of the first outside guide roller 621, then similarly wound around the second inside guide roller 612, the second outside guide roller 622, the third inside guide roller 613, the third outside guide roller 623, the fourth inside guide roller 614, the fourth outside guide roller 624, and the fifth inside guide roller 615 in this order, then fed from the Z2 side to the Z1 side, and wound around the roll 82 on the downstream side.

Therefore, the resin substrate 8 is fed while drawing a helical track clockwise as a whole as seen from the X1 side. That is, the resin substrate 8 is helically fed through a plurality of the inside guide rollers 611,... and the outside guide rollers 621,... provided in the deposition area and the non-deposition area as described above. Accordingly, the conveyor 6 is configured to feed the resin substrate 8 while passing the resin substrate 8 through the deposition area and the non-deposition area alternately.

However, when the resin substrate 8 passes through the deposition area, the resin substrate 8 is fed in the Y direction (from the Y1 side to the Y2 side) as illustrated in Fig. 9. In the production apparatus 4B of this embodiment in which the plasma source 52 is disposed on the Y1 side, the resin substrate 8 is fed so as to go away from the plasma source 52 at the time of passing the resin substrate 8 through the deposition area.

A method for producing a transparent gas barrier film will now be described. Hereinafter, a method for producing a transparent gas barrier film using the production apparatus 4B illustrated in Figs. 9 and 10 will be described, but the production method of the present invention is not limited to production using the production apparatus 4B.

Similarly to the first embodiment, the deposition area in the chamber 51 is arranged so that a material can be deposited on an adherend.

On the other hand, the long belt-shaped resin substrate 8 is drawn out from the roll 81 on the upstream side, and introduced into the chamber 51. In the illustrated example, rolls 81 and 82 are disposed outside the chamber 51, but may be disposed on the non-deposition area in the chamber 51.

The resin substrate 8 is wound around the guide rollers 611 and 621 of the conveyor 6, and the resin substrate 8 is fed so as to draw a helical track, and caused to pass through the deposition area and the non-deposition area alternately.

The conveyance speed of the resin substrate 8 can be appropriately set in consideration of the deposition rate and the thickness of a deposited layer formed etc., and is, for example, 0.1 to 20 m/minute.

When the resin substrate 8 sequentially passes through the deposition area (i.e. when the resin substrate 8 passes over the lower parts of the first to fifth inside guide rollers 611 to 615), the material is deposited on the resin substrate 8, so that deposited layers are formed one after another.

As described above, when the resin substrate 8 passes through the deposition area, the resin substrate 8 moves from the Y1 side to the Y2 side, and therefore goes away from the plasma source 52. Therefore, in the deposition area, the distance between the resin substrate 8 and the plasma source 52 is changed (changed to increase the distance in this case), so that a plurality of deposited layers each continuously changing in density in the thickness direction can be formed.

For promoting deposition in the deposition area, the surface temperature of the resin substrate 8 is set to, for example, 20°C to 200°C, preferably 80°C to 150°C.

Specifically, when the resin substrate 8 passes through the deposition area by way of the circumferential surface of the first inside guide roller 611, the material is deposited on a surface of the resin substrate 8 to form a first deposited layer. In this embodiment in which in the deposition area, the resin substrate 8 is fed so as to go away from the plasma source 52, the density of the material contained in the deposited layer gradually decreases. Thus, a first deposited layer 31 is formed in which the density on the surface side of the resin substrate 8 is the highest, and the density decreases as going away from the resin substrate 8 as illustrated in Fig. 8.

Thereafter, similarly the second to fifth deposited layers 32 to 35 each changing in density are sequentially formed on the surface of the first deposited layer 31. Accordingly, a transparent gas barrier layer including a plurality of deposited layers 31 to 35 each continuously changing in density in the thickness direction can be formed on the resin substrate 8. In this way, a deposited layer is formed each time the resin substrate 8 passes through the deposition area. When the production apparatus illustrated as an example in this embodiment is used, the number of deposited layers formed is identical to the number of inside guide rollers.

The production apparatus and the production method of this embodiment are also capable of efficiently producing a transparent gas barrier film including a plurality of layers each continuously changing in density in the thickness direction.

In the second embodiment, an apparatus and a method for forming a plurality of deposited layers each continuously decreasing in density as going away from a surface of the resin substrate 8 are illustrated as an example, but a plurality of deposited layers each continuously increasing in density as going away from a surface of the resin substrate 8 can also be formed.

These deposited layers may be formed by, for example, making modifications as described in (1) or (2) in the first embodiment.

In the second embodiment, a plurality of inside guide rollers 611. having the same diameter are used, but rollers having different diameters (not illustrated) may also be used for some of the inside guide rollers. By way of an example, guide rollers having a small diameter are used as the first to third inside guide rollers 611, 612, and 613, and guide rollers having a large diameter are used as the fourth to fifth inside guide rollers 614 and 615. In this case, comparison between passage of the resin substrate over the lower circumferential surface of the inside guide roller having a large diameter and passage of the resin substrate over the lower circumferential surface of the inside guide roller having a small diameter shows that when passing over the lower circumferential surface of the inside guide roller having a large diameter, the resin substrate 8 passes through the deposition area over a long time, so that a deposited layer having a large thickness can be formed.

- 1: Transparent gas barrier film
- 2: Resin substrate
- 3: Transparent gas barrier layer
- 31 to 35: First to fifth depositing layers
- 4A, 4B: Production apparatuses of transparent gas barrier film
- 51: Chamber
- 52: Plasma source
- 53: Deposition source
- 54: Reaction gas supply device
- 6, 7: Conveyor
- 611, 621, 71: Guide rollers

## Claims

1. A method for producing a transparent gas barrier film using a roll-to-roll method, the method comprising:
depositing a plurality of layers on a long belt-shaped resin substrate by alternately passing the resin substrate through a deposition area in which a material containing at least one of metals and semimetals is deposited by generating a plasma and a non-deposition area in which the material is not deposited, wherein
a transparent gas barrier layer including the plurality of layers each continuously changing in density in the thickness direction is formed on the resin substrate by changing a distance between the resin substrate and a plasma source in the deposition area.

2. The method for producing a transparent gas barrier film according to claim 1, wherein the change in distance is at least one of a change to increase the distance between the resin substrate and the plasma source and a change to decrease the distance between the resin substrate and the plasma source.

3. The method for producing a transparent gas barrier film according to claim 1 or 2, wherein the layer continuously changing in density contains at least one selected from the group consisting of an oxide, a nitride, a carbide, a nitride oxide, a carbide oxide, a carbide nitride, and a carbide nitride oxide.

4. An apparatus for producing a transparent gas barrier film including a transparent gas barrier layer including a plurality of layers each continuously changing in density in the thickness direction, the apparatus comprising:
a chamber having a deposition area and a non-deposition area; a plasma source that generates a plasma; a deposition source containing a material including at least one of metals and semimetals; and a conveyor that feeds a long belt-shaped resin substrate, wherein
the conveyor is configured to cause the resin substrate to pass through the deposition area and the non-deposition area alternately and feed the resin substrate so as to go away from or get closer to the plasma source when the resin substrate passes through the deposition area.

5. The apparatus for producing a transparent gas barrier film according to claim 4, wherein the conveyor is configured to feed the long belt-shaped resin substrate so as to draw a helical conveyance track.

6. The apparatus for producing a transparent gas barrier film according to claim 4 or 5,
wherein the deposition area has a part with the highest plasma density and a part with the lowest plasma density depending on plasma irradiation from the plasma source,
the conveyor has one guide roller around which the long belt-shaped resin substrate is helically wound, and
the guide roller has a shaft disposed in a direction orthogonally crossing a virtual line connecting the part with the highest plasma density and the part with the lowest plasma density.

7. The apparatus for producing a transparent gas barrier film according to claim 4 or 5,
wherein the deposition area has a part with the highest plasma density and a part with the lowest plasma density depending on plasma irradiation from the plasma source,
the conveyor has a plurality of guide rollers that feed the long belt-shaped resin substrate in a long direction, and
among the guide rollers, at least guide rollers provided in the deposition area each have a shaft disposed in a direction orthogonally crossing a virtual line connecting the part with the highest plasma density and the part with the lowest plasma density.

8. The apparatus for producing a transparent gas barrier film according to any one of claims 4 to 7, the apparatus further comprising a reaction gas supply device that supplies a reaction gas into the chamber.

9. An organic electroluminescence device comprising: a support substrate; and an organic electroluminescence layer formed on the support substrate and having a first electrode layer, an organic layer containing a light-emitting layer, and a second electrode layer, wherein the support substrate comprises a transparent gas barrier film obtained by the production method according to any one of claims 1 to 3.

10. An organic electroluminescence device comprising: a support substrate; an organic electroluminescence layer formed on the support substrate and having a first electrode layer, an organic layer containing a light-emitting layer, and a second electrode layer; and a sealing member for sealing the organic electroluminescence layer, wherein the sealing member comprises a transparent gas barrier film obtained by the production method according to any one of claims 1 to 3.
